# EUROPÄISCHE PATENTSCHRIFT

(11) **EP 2 407 014 B1**
(45) Veröffentlichungstag und Bekanntmachung des Hinweises auf die Patenterteilung: **17.05.2017**
(21) Anmeldenummer: 10709374.2
(22) Anmeldetag: 05.03.2010
(51) Int. Cl.: H05K 3/00, H05K 13/00

(54) **VERFAHREN UND SYSTEM ZUM VERBINDEN EINER MEHRZAHL VON LEITERPLATTEN MIT WENIGSTENS EINEM RAHMEN- BZW. TRÄGERELEMENT**
METHOD AND SYSTEM FOR CONNECTING A PLURALITY OF PRINTED CIRCUIT BOARDS TO AT LEAST ONE FRAME OR CARRIER ELEMENT
PROCÉDÉ ET SYSTÈME DE CONNEXION D'UNE PLURALITÉ DE CARTES DE CIRCUIT IMPRIMÉ À AU MOINS UN ÉLÉMENT SUPPORT OU CADRE

(30) Priorität: 09.03.2009 AT 13309 U
(43) Veröffentlichungstag der Anmeldung: 18.01.2012
(73) Patentinhaber: AT & S Austria Technologie & Systemtechnik Aktiengesellschaft, 8700 Leoben-Hinterberg (AT)
(72) Erfinder: THUMSER, Christoph, A-8010 Graz (AT)
(74) Vertreter: Miksovsky, Alexander
(86) Internationale Anmeldenummer: PCT/AT2010/000067
(87) Internationale Veröffentlichungsnummer: WO 2010/102315

(56) Entgegenhaltungen:
- EP-A1- 2 223 580
- WO-A1-2007/010595
- DE-A1- 19 600 928
- JP-A- 2005 038 953
- US-A1- 2003 178 725

## Beschreibung

Die vorliegende Erfindung bezieht sich auf ein Verfahren zum Verbinden einer Mehrzahl von Leiterplatten mit wenigstens einem Rahmen- bzw. Trägerelement, nach Anspruch 1. Die Erfindung bezieht sich darüber hinaus auf ein System zum Verbinden einer Mehrzahl von Leiterplatten mit wenigstens einem Rahmen- bzw. Trägerelement, nach Anspruch 11. Im Zusammenhang mit der Herstellung von Leiterplatten ist es bekannt, eine Mehrzahl von Leiterplatten bzw. Leiterplattenelementen auf einem gemeinsamen, plattenartigen Element herzustellen, wobei derartige Leiterplatten üblicherweise jeweils aus einer Mehrzahl von leitenden und isolierenden Schichten und/oder in einer derartigen Leiterplatte integrierten Bauteilen bestehen. Gemäß derart bekannten Herstellungsverfahren erfolgt ein im wesentlichen vollflächiger Aufbau einer Mehrzahl von Leiterplatten auf dem gemeinsamen plattenartigen Element, worauf nach Fertigstellung der Leiterplatten, diese voneinander getrennt werden. Hiebei weist jede Leiterplatte an ihrem Umfangsrand und somit außerhalb eines ein tatsächliches Leiterplattenelement bildenden, im wesentlichen zentralen Bereichs, in welchem die Strukturen zum Aufbau der Leiterplatte und/oder elektronische Bauteile integriert sind, einen entsprechenden Randbereich auf. Dieser ist vorgesehen, um weitere Bearbeitungsschritte einer derartigen Leiterplatte, wie beispielsweise im Rahmen einer Bestückung mit an wenigstens einer Oberfläche festzulegenden Komponenten und/oder eines Einbaus in eine elektrische oder elektronische Vorrichtung durchzuführen, um eine Handhabung und insbesondere ein automatisches Ergreifen einer derartigen Leiterplatte im Rahmen nachfolgender Be- bzw. Verarbeitungsschritte zu ermöglichen. Gemäß derzeit bekannten Verfahrensführungen ist somit davon auszugehen, dass der für den Rahmen bzw. Randbereich der Leiterplatte zur Verfügung zu stellende Umfangsbereich ebenfalls aus üblicherweise kostspieligem Material entsprechend der üblicherweise mehrlagigen Leiterplatte hergestellt wird. Ein derartiger Rand- bzw. Umfangsbereich, welcher für die Funktion der Leiterplatte im Hinblick auf einen üblicherweise mehrlagigen Aufbau aus kostspieligen Materialien nicht erforderlich ist, führt jedoch zu erhöhten Kosten einer derartigen Leiterplatte. Darüber hinaus ist davon auszugehen, dass im Rahmen von bekannten Herstellungsverfahren von Leiterplatten zwischen einzelnen Leiterplattenelementen liegende Bereiche bzw. Flächen des gemeinsamen plattenartigen Elements als Abfall verworfen werden, so dass auch in diesem Zusammenhang erhöhte Kosten für die Herstellung der Leiterplatten bzw. Leiterplattenelemente auflaufen.

Darüber hinaus ist es im Zusammenhang mit der Herstellung von Leiterplatten beispielsweise bekannt, einzelne schadhafte Leiterplatten auf einem gemeinsamen plattenartigen Element zu entfernen, falls diese im Verlauf von Tests bzw. Überprüfungen als schadhaft erkannt wurden, und anstelle von derartigen entfernten schadhaften Leiterplatten einzelne Leiterplatten einzusetzen.

Darüber hinaus sind Verfahren und Systeme der eingangs genannten Art zum gemeinsamen Bearbeiten und Handhaben von Leiterplatten bekannt, wonach in die Leiterplatten jeweils am gesamten Umfang umgebende Rahmenelemente üblicherweise mehrere Leiterplatten bzw. Leiterplattenelemente eingesetzt und daran beispielsweise durch ein Verkleben festgelegt werden. Hiebei kann beispielsweise auf die DE-A 196 00 928, die hiezu korrespondierende US-A 5 866 852, die DE-A 101 55 829, die US-PS 4,689,103 oder die US-PS 5,044,615 verwiesen werden. Nachteilig bei diesen bekannten Verfahren zum Einsetzen von Leiterplatten in ein die Leiterplatten jeweils vollständig umgebendes Rahmenelement ist insbesondere die Tatsache, dass die für die Anordnung der Leiterplatten in dem Rahmenelement vorzusehenden Aufnahmeöffnungen exakt an die Abmessungen der einzusetzenden Leiterplatten angepasst werden müssen und dadurch eine ordnungsgemäße Festlegung beispielsweise mit Hilfe einer Verklebung an den Umfangsrändern der üblicherweise eine vergleichsweise geringe Dicke aufweisenden Leiterplatten und Rahmenelemente äußerst schwierig und aufwendig ist.

Aus der JP 2005/038953 A ist ein Verfahren zum Ersetzen eines defekten Elements in einer Leiterplatte bekannt geworden, wobei ein defektes Leiterplattenelement entfernt wird und durch ein neues Element durch teilweises Umgeben mittels eines Rahmen- bzw. Trägerelements ersetzt wird. Aus der US 2003/0178725 A1 ist die Verwendung von unterschiedlichen Kopplungselementen bei einer Aufnahme eines Leiterplattenelements in einem Rahmen- bzw. Trägerelement bekannt.

Eine weitere abgewandelte Ausführungsform eines Verfahrens zur Herstellung einer Leiterplatte, wobei ein Leiterplattenelement mit einem Trägerelement koppelbar ist, ist beispielsweise der WO 2007/010595 A1 zu entnehmen.

Die vorliegende Erfindung zielt daher darauf ab, ein Verfahren sowie ein System zum Verbinden einer Mehrzahl von Leiterplatten mit wenigstens einem Rahmen- bzw. Trägerelement dahingehend weiterzubilden, dass eine einfache und zuverlässige Verbindung zwischen derartigen Leiterplatten und wenigstens einem Rahmen- bzw. Trägerelement für nachfolgende Bearbeitungsschritte zur Verfügung gestellt wird. Durch eine derartige einfache Verbindung sollen darüber hinaus die Kosten für die Herstellung der Leiterplatten bei einer weiteren Be- bzw. Verarbeitung derselben reduziert bzw. optimiert werden, wobei darüber hinaus für das wenigstens eine Rahmen- bzw. Trägerelement mit einem gegenüber dem für die insbesondere mehrlagige Leiterplatte eingesetzten Material kostengünstiger und einfacher herstellbaren Material das Auslangen gefunden werden soll.

Zur Lösung dieser Aufgaben ist ein Verfahren zum Verbinden einer Mehrzahl von Leiterplatten mit wenigstens einem Rahmen- bzw. Trägerelement im wesentlichen dadurch gekennzeichnet, dass das wenigstens eine Kopplungselement der Leiterplatte von einem einen sich verjüngenden Querschnitt aufweisenden Kopplungselement gebildet wird und dass die Kopplung bzw. Verbindung der Leiterplatten mit dem wenigstens einen Rahmen- bzw. Trägerelement in einer horizontalen Anordnung bzw. Positionierung geschieht.

Durch das erfindungsgemäße Verfahren wird es somit möglich, eine Mehrzahl von Leiterplatten unter entsprechender Ausnutzung des für die insbesondere mehrlagige Leiterplatte eingesetzten und üblicherweise kostspieligen Materials zur Verfügung zu stellen, wobei auf für weitere Bearbeitungsschritte erforderliche Rahmen- bzw. Trägerelemente unter zusätzlichem Materialaufwand während der Herstellung der einzelnen Leiterplatten verzichtet werden kann. Für eine einfache Kopplung bzw. Verbindung mit wenigstens einem Rahmen- bzw. Trägerelement ist an wenigstens einem Rand bzw. einer Seitenkante jeder Leiterplatte jeweils ein einfach herzustellendes Kopplungselement vorgesehen bzw. ausgebildet. Darüber hinaus wird vorgeschlagen, das wenigstens eine Rahmen- bzw. Trägerelement mit zu dem wenigstens einen Kopplungselement der Leiterplatten jeweils komplementären Kopplungselementen zu versehen, wobei ein derartiges Rahmen- bzw. Trägerelement insbesondere aus einem gegenüber dem Material der Leiterplatte kostengünstigeren und gegebenenfalls einfacheren Material hergestellt werden kann, so dass insgesamt die Materialkosten für die Herstellung einzelner Leiterplatten verringert werden. Durch Vorsehen von wenigstens einem Kopplungselement an jeweils wenigstens einem Rand der einzelnen Leiterplatten sowie Kopplungselementen an dem wenigstens einen Rahmen- bzw. Trägerelement wird ein einfaches Verbinden bzw. Koppeln der Leiterplatte mit dem wenigstens einen Rahmen- bzw. Trägerelement ermöglicht. Darüber hinaus ist insbesondere zur weiteren Materialeinsparung vorgesehen, dass das wenigstens eine Rahmen- bzw. Trägerelement die Leiterplatten lediglich über einen Teilbereich des Umfangs umgibt bzw. umschließt. Ein derartiges, lediglich teilweises Umschließen bzw. Umgeben ist für weitere Be- bzw. Verarbeitungsschritte der Leiterplatten ausreichend und ermöglicht darüber hinaus gegenüber bekanntem Stand der Technik, bei welchem üblicherweise ein Umschließen der einzelnen Leiterplatten über den gesamten Umfang durch ein Rahmen- bzw. Trägerelement bei entsprechend erhöhtem Aufwand für ein Verbinden bzw. Koppeln vorgesehen war, dass weitere Vereinfachungen bei einer Herstellung der Leiterplatten erzielbar sind. Durch Vorsehen eines sich verjüngenden Querschnitts lässt sich darüber hinaus ein einfaches Zusammenfügen eines Kopplungselements mit einem komplementären Kopplungselement erzielen. Weiters lässt sich durch die horizontale Ausrichtung bzw. Positionierung die Bearbeitung vereinfachen bzw. eine Automatisierung unterstützen.

Eine derartige weitere Be- bzw. Verarbeitung der Leiterplatten kann beispielsweise im Rahmen einer Bestückung mit zusätzlichen Bauteilen an wenigstens einer Oberfläche der mit dem wenigstens einen Rahmen- bzw. Trägerelement verbundenen Leiterplatten erfolgen. Darüber hinaus kann durch ein Ergreifen des am Umfang der Leiterplatten angeordneten bzw. festgelegten Rahmen- bzw. Trägerelements auch ein Einsetzen der Leiterplatte in eine elektrische oder elektronische Vorrichtung erfolgen. Entsprechend dem Einsatzzweck kann nach fertiggestellter Bearbeitung der Leiterplatte das Rahmen- bzw. Trägerelement wieder von den Leiterplatten getrennt werden, um die Leiterplatte beispielsweise in eine elektrische oder elektronische Vorrichtung einzusetzen. Alternativ kann neben der Möglichkeit, dass das Rahmen- bzw. Trägerelement während des Einsatzes in einer elektrischen oder elektronischen Vorrichtung an der Leiterplatte verbleibt, auch vorgesehen sein, dass eine Trennung von zumindest Teilbereichen des vorgesehenen Rahmen- bzw. Trägerelements entsprechend dem Einsatzzweck und/oder entsprechend dem für einen Einsatz der Leiterplatte zur Verfügung stehenden Raum entfernt wird.

Für eine ordnungsgemäße und einfache Verbindung der Leiterplatten mit dem wenigstens einen Rahmen- bzw. Trägerelement wird gemäß einer bevorzugten Ausführungsform des erfindungsgemäßen Verfahrens vorgeschlagen, dass das jeweils wenigstens eine Kopplungselement der Leiterplatten und die komplementären Kopplungselemente des Rahmen- bzw. Trägerelements formschlüssig verbunden werden.

Zur weiteren Verbesserung bzw. Sicherstellung der Verbindung zwischen der Mehrzahl von Leiterplatten und dem wenigstens einen Rahmen- bzw. Trägerelement wird gemäß einem weiters bevorzugten Verfahren vorgeschlagen, dass das wenigstens eine Kopplungselement der Leiterplatten mit den komplementären Kopplungselementen des Rahmen- bzw. Trägerelements verklebt wird. Insbesondere abhängig von den weiteren Be- bzw. Verarbeitungsschritten werden hierbei im Rahmen der Herstellung einer Leiterplatte üblicherweise eingesetzte bzw. verwendete Kleber vorgesehen, wobei beispielsweise UV-härtende Kleber besonders günstig und rasch sowie zuverlässig einsetzbar sind.

Zur Bereitstellung einer einfach herstellbaren und zuverlässigen Kopplung bzw. Verbindung zwischen der einzelnen Leiterplatte und dem wenigstens einen Rahmen- bzw. Trägerelement wird darüber hinaus vorgeschlagen, dass das wenigstens eine Kopplungselement der Leiterplatten von einem profilierten, von einem Rand der Leiterplatte vorragenden Kopplungselement gebildet wird, welches in einer komplementären Ausnehmung bzw. Vertiefung des Rahmen- bzw. Trägerelements aufgenommen wird, wie dies einer weiters bevorzugten Ausführungsform des erfindungsgemäßen Verfahrens entspricht.

In diesem Zusammenhang wird gemäß einer weiters bevorzugten Ausführungsform vorgeschlagen, dass das wenigstens eine Kopplungselement der Leiterplatte von einem einen dreieckigen Querschnitt aufweisenden Kopplungselement gebildet wird. Ein derartiger sich verjüngender bzw. dreieckiger Querschnitt für ein Kopplungselement erlaubt ein einfaches und zuverlässiges Zusammenpassen bzw. Einpassen des Kopplungselements der Leiterplatte in das komplementäre Kopplungselement in Form einer Ausnehmung bzw. Vertiefung des Rahmen- bzw. Trägerelements. Durch die sich verjüngende Form eines dreieckigen Querschnitts ist eine einfache, selbsttätige Zentrierung der Leiterplatte relativ zu dem Rahmen- bzw. Trägerelement bzw. zu der Festlegungsposition daran erzielbar.

Für eine entsprechend einfache und zuverlässige Handhabung der einzelnen Leiterplatten während nachfolgender Be- bzw. Verarbeitungsschritte wird darüber hinaus gemäß einer weiters bevorzugten Ausführungsform vorgeschlagen, dass eine Mehrzahl von Leiterplatten voneinander beabstandet mit dem wenigstens einen Rahmen- bzw. Trägerelement verbunden wird. Ein derartiger Abstand zwischen den einzelnen an dem wenigstens einen Rahmen- bzw. Trägerelement festgelegten bzw. angeordneten Leiterplatten kann hierbei insbesondere in Anpassung an weitere Be- bzw. Verarbeitungsschritte erfolgen.

Um insbesondere einseitige Belastungen der einzelnen Leiterplatten zu vermeiden und eine gleichmäßige Halterung der einzelnen Leiterplatten während einzelner, nachfolgender Verfahrensschritte zu ermöglichen, wird darüber hinaus vorgeschlagen, dass die Leiterplatten an zwei gegenüberliegenden Rändern mit jeweils wenigstens einem Kopplungselement ausgebildet werden, welche mit an den gegenüberliegenden Rändern der Leiterplatten vorgesehenen Rahmen- bzw. Trägerelementen zusammenwirken, wie dies einer weiters bevorzugten Ausführungsform des erfindungsgemäßen Verfahrens entspricht. Derart können die einzelnen Leiterplatten an zwei gegenüberliegenden Rändern bzw. Seiten jeweils mit einem Rahmen- bzw. Trägerelement verbunden bzw. gekoppelt werden, so dass die nebeneinander und bevorzugt beabstandet voneinander angeordneten Leiterplatten über die vorgesehenen Rahmen- bzw. Trägerelemente jeweils an beiden Seiten bzw. Enden der Leiterplatten gehalten und beispielsweise gehandhabt bzw. ergriffen werden können.

Für ein insbesondere automatisiertes Verbinden bzw. Koppeln der Mehrzahl von Leiterplatten mit dem wenigstens einen Rahmen- bzw. Trägerelement wird gemäß einer weiters bevorzugten Ausführungsform des erfindungsgemäßen Verfahrens vorgeschlagen, dass eine Mehrzahl von voneinander beabstandeten Leiterplatten auf einem Förderelement in eine für eine Verbindung mit dem wenigstens einen Rahmen- bzw. Trägerelement vorgesehene gegenseitige Positionierung gebracht wird, dass das wenigstens eine Rahmen- bzw. Trägerelement in einer auf die Zufuhrrichtung der Leiterplatten im wesentlichen normalen Zufuhrrichtung in Richtung zu den mit den Kopplungselementen versehenen Rändern der Leiterplatten bewegt wird und dass die Kopplungselemente der Leiterplatten mit den Kopplungselementen des Rahmen- bzw. Trägerelements gekoppelt bzw. verbunden werden. Es wird somit erfindungsgemäß möglich, die Verbindung zwischen den Leiterplatten und dem wenigstens einen Rahmen- bzw. Trägerelement im wesentlichen vollständig zu automatisieren, so dass wiederum die Kosten für die Herstellung einzelner Leiterplatten durch ein vereinfachtes und durch die Automatisierung auch beschleunigtes Verfahren weiter gesenkt werden können.

Bei Vorsehen einer Kopplung der einzelnen Leiterplatten an zwei einander gegenüberliegenden Rändern bzw. Seiten mit jeweils wenigstens einem Rahmen- bzw. Trägerelement, wie dies oben für eine bevorzugte Ausführungsform des erfindungsgemäßen Verfahrens erörtert wurde, wird ebenfalls für eine Automatisierung der Kopplung bzw. Verbindung erfindungsgemäß bevorzugt vorgeschlagen, dass nach einer Positionierung einer Mehrzahl von Leiterplatten an einer für eine Kopplung vorgesehenen Position zwei Rahmen- bzw. Trägerelemente in zueinander entgegengesetzten Richtungen in Richtung zu den mit den Kopplungselementen versehenen Leiterplatten bewegt und mit diesen verbunden werden.

Zur weiteren Unterstützung der korrekten Verbindung bzw. Kopplung zwischen den Leiterplatten und dem wenigstens einen Rahmen- bzw. Trägerelement insbesondere im Rahmen einer automatisierten Verbindung wird gemäß einer weiters bevorzugten Ausführungsform vorschlagen, dass die Leiterplatten und/oder Rahmen- bzw. Trägerelemente während der Kopplung miteinander durch Halte- bzw. Klemmelemente positioniert und gehalten werden.

Zur Lösung der eingangs genannten Aufgaben ist darüber hinaus ein System zum Verbinden einer Mehrzahl von Leiterplatten mit wenigstens einem Rahmen- bzw. Trägerelement der eingangs genannten Art im wesentlichen dadurch gekennzeichnet, dass das wenigstens eine Kopplungselement der Leiterplatte von einem einen sich verjüngenden Querschnitt aufweisenden Kopplungselement gebildet ist und dass die Kopplung bzw. Verbindung der Leiterplatten mit dem wenigstens einen Rahmen- bzw. Trägerelement in einer horizontalen Anordnung bzw. Positionierung geschehen kann, wobei die Leiterplatten und das wenigstens eine Rahmen- bzw. Trägerelement bei der Kopplung bzw. Verbindung auf gleicher Höhe bzw. in einer Ebene angeordnet sein können. Wie bereits oben ausgeführt, gelingt somit eine insbesondere kostengünstige Herstellung einer Mehrzahl von Leiterplatten als auch des jeweils wenigstens einen Rahmen- bzw. Trägerelements, wobei diese in weiterer Folge einfach und zuverlässig verbunden werden können. Durch Vorsehen eines sich verjüngenden Querschnitts lässt sich darüber hinaus ein einfaches Zusammenfügen eines Kopplungselements mit einem komplementären Kopplungselement erzielen und es lässt sich durch die horizontale Ausrichtung bzw. Positionierung die Bearbeitung vereinfachen.

Im Hinblick auf die Bereitstellung von einfach herzustellenden und zuverlässigen Kopplungselementen wird erfindungsgemäß bevorzugt vorgeschlagen, dass das jeweils wenigstens eine Kopplungselement der Leiterplatten von einem profilierten, von einem Rand der Leiterplatte vorragenden Kopplungselement gebildet ist, welches in einer komplementären Ausnehmung bzw. Vertiefung des Rahmen- bzw. Trägerelements aufnehmbar ist.

Darüber hinaus wird für eine einfache und zuverlässige Handhabung bei einer Kopplung sowie eine im wesentlichen selbsttätige Zentrierung bei einer Verbindung zwischen jeweils einer Leiterplatte und dem wenigstens einen Rahmen- bzw. Trägerelement darüber hinaus bevorzugt vorgeschlagen, dass das wenigstens eine Kopplungselement der Leiterplatte von einem einen sich verjüngenden Querschnitt, insbesondere dreieckigen Querschnitt aufweisenden Kopplungselement gebildet ist.

Darüber hinaus wird für eine einfache und zuverlässige Kopplung sowie eine im wesentlichen selbsttätige Zentrierung bei einer Verbindung zwischen jeweils einer Leiterplatte und dem wenigstens einen Rahmen- bzw. Trägerelement darüber hinaus vorgeschlagen, dass das wenigstens eine Kopplungselement der Leiterplatte von einem einen dreieckigen Querschnitt aufweisenden Kopplungselement gebildet ist, wie dies einer weiters bevorzugten Ausführungsform des erfindungsgemäßen Systems entspricht.

Für eine besonders einfache Herstellung der Kopplungselemente des Rahmen- bzw. Trägerelements wird gemäß einer weiters bevorzugten Ausführungsform vorgeschlagen, dass die Kopplungselemente des Rahmen- bzw. Trägerelements von jeweils einem von der Oberfläche des Rahmen- bzw. Trägerelements abgesetzten Teilbereich gebildet sind, in welchen jeweils ein Kopplungselement einer Leiterplatte einpassbar ist.

Gemäß einer alternativen bevorzugten Ausführungsform wird für eine einfache Herstellung der Kopplungselemente des Rahmen- bzw. Trägerelements erfindungsgemäß vorgeschlagen, dass die Kopplungselemente des Rahmen- bzw. Trägerelements von an einem Seitenrand, welcher zu den Leiterplatten gerichtet ist, gebildeten Hohlräumen bzw. Vertiefungen gebildet sind.

Wie bereits oben angeführt, kann zur weiteren Verbesserung der Handhabbarkeit und zur Vergleichmäßigung von gegebenenfalls auf die Leiterplatte während der Herstellung einwirkenden Kräften darüber hinaus bevorzugt vorgesehen sein, dass die Leiterplatten an zwei gegenüberliegenden Rändern mit jeweils wenigstens einem Kopplungselement ausgebildet sind, welche mit an den gegenüberliegenden Rändern der Leiterplatte vorgesehenen Rahmen- bzw. Trägerelementen zusammenwirken.

Es kann darüber hinaus eine Leiterplatte zur Verfügung gestellt werden, welche an wenigstens einem Rand mit wenigstens einem Kopplungselement für ein Koppeln mit einem Rahmen- bzw. Trägerelement ausgebildet ist und wobei das wenigstens eine Kopplungselement der Leiterplatte von einem einen sich verjüngenden Querschnitt aufweisenden Kopplungselement gebildet ist. Es lässt sich somit eine einfach herstellbare Leiterplatte zur Verfügung stellen, welche einfach mit wenigstens einem Rahmen- bzw. Trägerelement verbunden werden kann. Durch Vorsehen eines sich verjüngenden Querschnitts lässt sich darüber hinaus ein einfaches Zusammenfügen eines Kopplungselements mit einem komplementären Kopplungselement erzielen.

Für eine Kopplung einer derartigen Leiterplatte mit jeweils einem Rahmen- bzw. Trägerelement an zwei einander gegenüberliegenden Seiten kann vorgesehen sein, dass die Leiterplatte an zwei gegenüberliegenden Rändern mit jeweils wenigstens einem Kopplungselement ausgebildet ist, welche mit an den gegenüberliegenden Rändern der Leiterplatten vorgesehenen Rahmen- bzw. Trägerelementen zusammenwirken.

Für eine besonders einfache und zuverlässige Zentrierung einer Leiterplatte relativ zu dem wenigstens einen, damit zu koppelnden bzw. zu verbindenden Rahmen- bzw. Trägerelement kann vorgesehen sein, dass das wenigstens eine Kopplungselement der Leiterplatte von einem einen dreieckigen Querschnitt aufweisenden Kopplungselement gebildet ist.

Es kann darüber hinaus ein Rahmen- bzw. Trägerelement zur Verfügung gestellt werden, welches mit einer Mehrzahl von zu Kopplungselementen von damit verbindbaren Leiterplatten komplementären Kopplungselementen versehen ist. Wie bereits oben ausgeführt, lässt sich somit in einfacher und zuverlässiger Weise ein Rahmen- bzw. Trägerelement mit für eine Kopplung bzw. Verbindung mit der Mehrzahl von Leiterplatten erforderlichen, komplementären Kopplungselementen zur Verfügung stellen.

Für eine zuverlässige Kopplung mit einer Mehrzahl von Leiterplatten kann vorgesehen sein, dass die Kopplungselemente des Rahmen- bzw. Trägerelements von jeweils einem von der Oberfläche des Rahmen- bzw. Trägerelements abgesetzten Teilbereich gebildet sind, in welchen jeweils ein Kopplungselement einer Leiterplatte einpaßbar ist.

Alternativ kann für eine zuverlässige Verbindung mit einer Mehrzahl von Leiterplatten vorgesehen sein, dass die Kopplungselemente des Rahmen- bzw. Trägerelements von an einem Seitenrand, welcher zu den Leiterplatten gerichtet ist, gebildeten Hohlräumen bzw. Vertiefungen gebildet sind.

Derart abgesetzte Teilbereiche bzw. Hohlräume oder Vertiefungen als Kopplungselemente des Rahmen- bzw. Trägerelements können durch Entfernen von einzelnen Schichten bzw. Lagen eines mehrlagigen Rahmen- bzw. Trägerelements zur Verfügung gestellt werden. Falls zur Entfernung derartiger Teilbereiche entsprechende Materialien bzw. Schichten eingesetzt werden, welche während der Herstellung des mehrlagigen Rahmen- bzw. Trägerelements ein Anhaften zwischen einzelnen Teilbereichen verhindern, welche nachfolgend die Hohlräume bzw. Vertiefungen ausbilden, kann ein derartiges, ein Anhaften verhinderndes Material in weiterer Folge und bei Einsatz entsprechender Verfahrensschritte dafür herangezogen werden, eine Kopplung mit den Kopplungselementen der einzelnen Leiterplatten zu unterstützen bzw. zur Verfügung zu stellen, so dass beispielsweise auf die Verwendung eines zusätzlichen Klebers verzichtet werden kann.

Wie bereits oben angeführt, kann ein derartiges Rahmen- bzw. Trägerelement insbesondere aus einem gegenüber dem Material für die Leiterplatten kostengünstigeren Material hergestellt werden. Hiebei kann vorgesehen sein, dass das Rahmen- bzw. Trägerelement wiederverwendbar ausgebildet ist. Bei einer derartigen Wiederverwendbarkeit bzw. -verwertbarkeit von Rahmen- bzw. Trägerelementen können die Kosten für die Herstellung derartiger Leiterplatten bzw. Leiterplattenelemente weiter reduziert werden, da die bereits gegenüber bekannten Verfahren verringerten Kosten der zur Verfügung zu stellenden Rahmen- bzw. Trägerelemente durch mehrfachen Einsatz derselben auf eine entsprechend erhöhte Anzahl von herzustellenden Leiterplatten verteilt werden können.

Die Erfindung wird nachfolgend anhand von in der beiliegenden Zeichnung schematisch dargestellten Ausführungsbeispielen näher erläutert. In dieser zeigen:
Fig. 1 eine schematische Draufsicht auf eine Mehrzahl von Leiterplatten, welche an einander gegenüberliegenden Rändern bzw. Seiten mit jeweils einem gemeinsamen Rahmen- bzw. Trägerelement entsprechend dem Verfahren und System gemäß der vorliegenden Erfindung verbindbar sind, in einem Zustand vor einer Verbindung bzw. Kopplung zwischen den Leiterplatten und den Rahmen- bzw. Trägerelementen;
Fig. 2 eine schematische Seitenansicht entsprechend Pfeil II der Fig. 1 in vergrößertem Maßstab, wobei Fig. 1 eine Ansicht entsprechend Pfeil I der Fig. 2 darstellt;
Fig. 3 eine schematische Draufsicht auf ein automatisiertes, erfindungsgemäßes Verfahren zum Verbinden jeweils einer Mehrzahl von Leiterplatten mit wenigstens einem Rahmen- bzw. Trägerelement;
Fig. 4 eine schematische Schnitt- bzw. Seitenansicht der in Fig. 3 dargestellten Ausführungsform in vergrößertem Maßstab, wobei Fig. 3 eine Ansicht entsprechend Pfeil III der Fig. 4 darstellt;
Fig. 5 in einer zu Fig. 1 ähnlichen Darstellung eine schematische Draufsicht auf eine abgewandelte Ausführungsform einer Mehrzahl von Leiterplatten sowie damit zu verbindenden Rahmen- bzw. Trägerelementen für einen Einsatz in einem erfindungsgemäßen Verfahren sowie System in einem Zustand vor einer Verbindung der Leiterplatten mit den Rahmen- bzw. Trägerelementen;
Fig. 6 einen Schnitt entlang der Linie VI-VI der Fig. 5 in vergrößertem Maßstab, wobei Fig. 5 eine Darstellung entsprechend Pfeil V der Fig. 6 darstellt;
Fig. 7 in vergrößertem Maßstab ein Detail in einer Draufsicht auf ein Kopplungselement einer Leiterplatte sowie des damit zu verbindenden Rahmen- bzw. Trägerelements, wobei darüber hinaus ein Aufbringen von Klebstoff angedeutet ist; und
Fig. 8 eine Schnittansicht entsprechend der Linie VIII-VIII der Fig. 7.

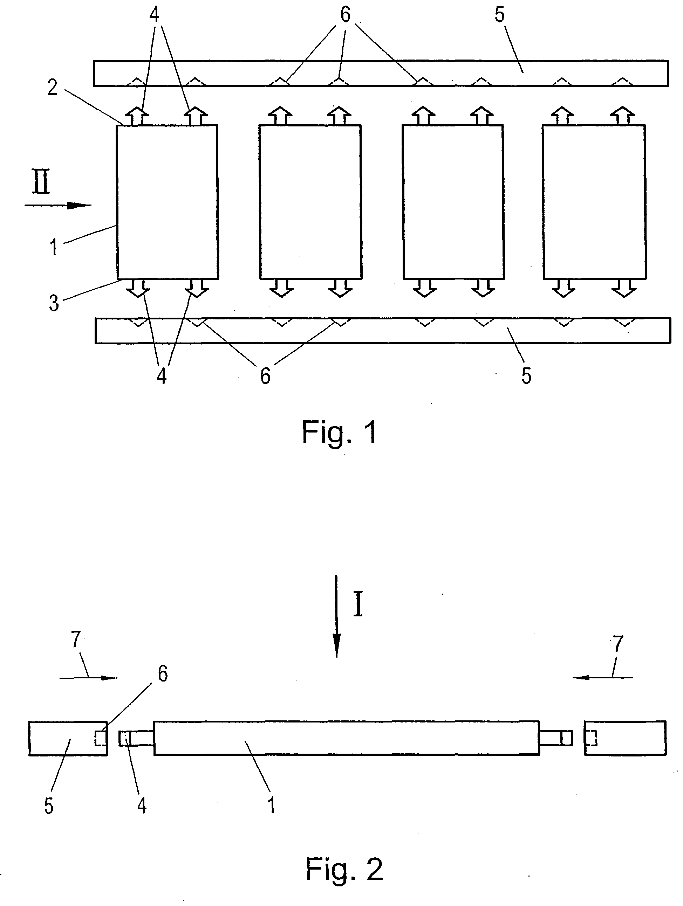

In Fig. 1 ist schematisch eine Mehrzahl von Leiterplatten 1 gezeigt, welche in an sich bekannten vorangehenden Verfahrensschritten beispielsweise in Form einer mehrlagigen Leiterplatte hergestellt wurden, wobei die Leiterplatten 1 bei der in Fig. 1 dargestellten Ausführungsform an einander gegenüberliegenden Seitenrändern bzw. -kanten 2 und 3 jeweils mit zwei Kopplungselementen 4 ausgebildet sind.

Bei der Ausbildung gemäß Fig. 1 sind die Kopplungselemente 4 jeweils mit einem sich verjüngenden Querschnitt und insbesondere einem in Draufsicht dreieckigen Querschnitt ausgebildet.

Darüber hinaus ist gemäß Fig. 1 vorgesehen, daß zu den Rändern 2 bzw. 3 der Leiterplatten 1 gewandt jeweils ein Rahmen- bzw. Trägerelement 5 vorgesehen ist, welches mit zu den Kopplungselementen 4 der Leiterplatten 1 korrespondierenden bzw. komplementären Kopplungselementen in Form von Hohlräumen bzw. Vertiefungen 6 ausgebildet ist.

Für eine Verbindung bzw. Kopplung der Leiterplatten 1 mit den Rahmen- bzw. Trägerelementen 5 werden die Rahmen- bzw. Trägerelemente 5 in Richtung zu den Leiterplatten 1 bewegt, wie dies schematisch in Fig. 2 durch einen Pfeil 7 angedeutet ist, so daß die Kopplungselemente 4 der Leiterplatten 1 in die Hohlräume bzw. Vertiefungen als Kopplungselemente 6 der Rahmen- bzw. Trägerelemente 5 eintreten, wodurch eine Verbindung bzw. Kopplung zwischen den Rahmen- bzw. Trägerelementen 5 sowie den Leiterplatten 1 erzielbar ist.

Wie aus Fig. 1 und 2 ersichtlich, umgeben hiebei die Rahmen- bzw. Trägerelemente 5 die einzelnen Leiterplatten 1 lediglich über einen Teilbereich ihres Umfangs, wobei darüber hinaus die Leiterplatten 1 voneinander beabstandet an den Rahmen- bzw. Trägerelementen 5 gelagert werden.

Nach einer derartigen Verbindung zwischen den einzelnen Rahmen- bzw. Trägerelementen 5 und der Mehrzahl von Leiterplatten 1 erfolgen weitere Be- bzw. Verarbeitungsschritte an den einzelnen Leiterplatten 1, beispielsweise in Form einer Bestückung derselben.

Durch Ausbilden der Kopplungselemente 5 in Form eines Dreiecks bzw. mit sich verjüngendem Querschnitt kann eine einfache und zuverlässige Zentrierung der Leiterplatten 1 relativ zu den Kopplungselementen 6 der Rahmen- bzw. Trägerelemente 5 erfolgen.

Durch ein formschlüssiges Zusammenpassen der Kopplungselemente 4 und 6 der Leiterplatten 1 sowie der Rahmen- bzw. Trägerelemente 5 erfolgt eine zuverlässige Verbindung zwischen den einzelnen Elementen sowie Festlegung daran.

Falls die Hohlräume bzw. Vertiefungen 6 der Rahmen- bzw. Trägerelemente durch ein Entfernen von Teilbereichen nach einem Vorsehen bzw. Aufbringen von ein Anhaften verhinderndem Material hergestellt werden, kann durch geeignete Be- bzw. Verarbeitungsschritte im Zusammenhang mit der Kopplung bzw. Verbindung der Leiterplatten 1 sowie den Rahmen- bzw. Trägerelementen 5 sichergestellt werden, daß eine Verbindung im Bereich der Kopplungselemente 4 und 6 insbesondere ohne Vorsehen eines zusätzlichen Klebens möglich wird.

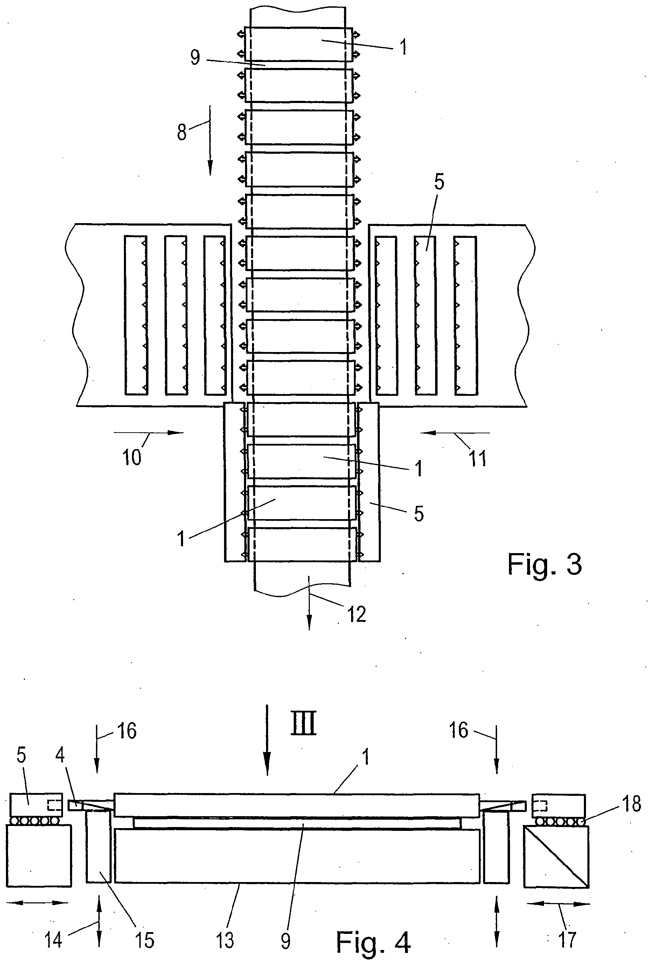

In Fig. 3 und 4 ist eine automatisierte Verbindung bzw. Kopplung zwischen wiederum mit 1 bezeichneten Leiterplatten und mit 5 bezeichneten Rahmen- bzw. Trägerelementen schematisch dargestellt.

Hiebei erfolgt entsprechend dem Pfeil 8 eine Zufuhr einzelner Leiterplattenelemente bzw. Leiterplatten 1 auf einem schematisch mit 9 angedeuteten Förderelement.

Bei Erreichen der mittig dargestellten Position der entsprechenden Anzahl von Leiterplatten 1 erfolgt bei Vorsehen von wiederum zwei Rahmen- bzw. Trägerelementen 5 an gegenüberliegenden Rändern bzw. Seitenkanten der Leiterplatten 1 und einer Bewegung entsprechend den Pfeilen 10 und 11 eine im wesentlichen automatisierte Kopplung zwischen den Leiterplatten 1 und den damit zu verbindenden Rahmen- bzw. Trägerelementen 5.

Nach einer Kopplung der Leiterplatten 1 mit den Rahmen- bzw. Trägerelementen 5, wie dies im unteren Bereich von Fig. 3 dargestellt ist, erfolgt eine Entfernung des Systems, bestehend aus einer Mehrzahl von Leiterplatten 1 und wenigstens einem Rahmen- bzw. Trägerelement 5 entsprechend dem Pfeil 12.

In Fig. 4 ist in vergrößertem Maßstab schematisch ein Tisch bzw. Support 13 dargestellt, auf welchem über das Förderband 9 jeweils die Leiterplatten 1 zugeführt werden.

Für eine korrekte Positionierung relativ zu den von den Seiten zuzuführenden Rahmen- bzw. Trägerelementen 5 sind entsprechend dem Doppelpfeil 14 heb- und senkbare Abstützelemente 15 im Bereich der Kopplungselemente 4 angedeutet.

Für eine korrekte Positionierung kann darüber hinaus ein Klemmen bzw. Festlegen der einzelnen Leiterplatten 1 bei Erreichen der für eine Verbindung ordnungsgemäßen Position entsprechend den Pfeilen 16 erfolgen, wobei derartige Positionier- bzw. Klemmeinrichtungen für sich gesehen bekannt sind.

Für die Zufuhr der Rahmen- bzw. Trägerelemente 5 sind entsprechend dem Doppelpfeil 17 bewegbare Förderelemente 18 angedeutet.

Wie insbesondere aus den Darstellungen von Fig. 3 und 4 ersichtlich, läßt sich ein Verbinden der Leiterplatten 1 und des wenigstens einen Rahmen- bzw. Trägerelements 5 nicht nur weitestgehend automatisiert, sondern auch in einer horizontalen Anordnung bzw. Positionierung vornehmen, so daß auch die Verfahrensschritte zum Verbinden bzw. Zusammenbauen der einzelnen Elemente 1 und 5 vereinfacht und gegebenenfalls beschleunigt werden können.

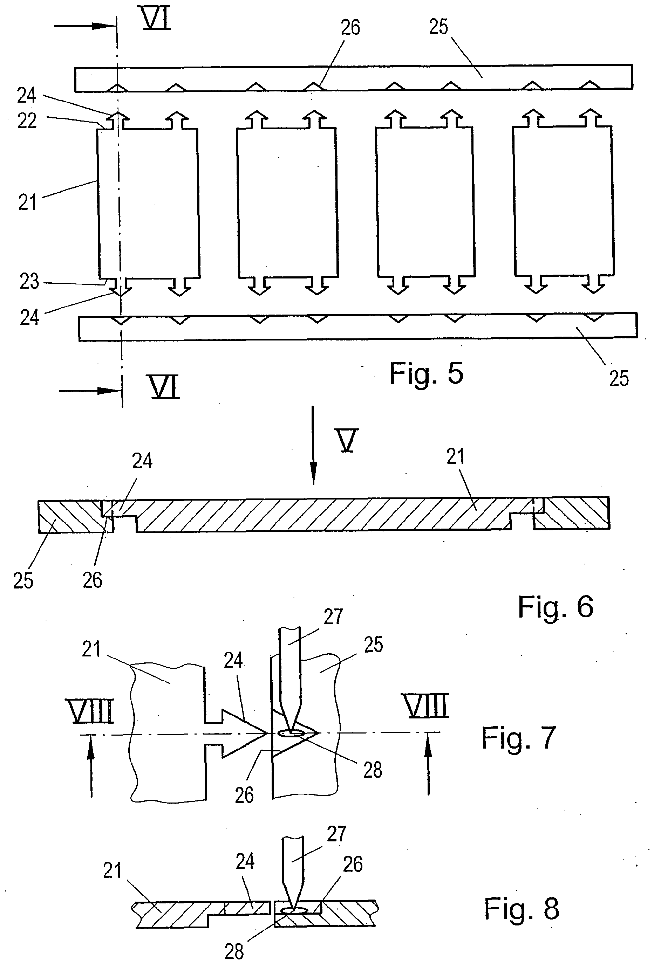

Bei der in Fig. 5 und 6 dargestellten abgewandelten Ausführungsform ist eine Mehrzahl von Leiterplatten mit 21 bezeichnet, welche wiederum an einander gegenüberliegenden Rändern bzw. Seitenkanten 22 und 23 mit Kopplungselementen 24 ausgebildet sind. Ähnlich wie bei der Ausführungsform der Fig. 1 und 2 weisen die Kopplungselemente 24 einen sich verjüngenden und insbesondere dreieckigen Querschnitt auf, welcher in weiterer Folge ein vereinfachtes Zentrieren und Festlegen an Rahmen- bzw. Trägerelementen 25 ermöglicht, welche mit zu den Kopplungselementen 24 komplementären Kopplungselementen in Form von abgesetzten Bereichen bzw. Vertiefungen 26 ausgebildet sind.

Während bei der Ausführungsform gemäß Fig. 1 und 2 die Kopplungselemente 4 der Leiterplatten 1 in Hohlräume bzw. Vertiefungen 6 an den Seitenrändern der Rahmen- bzw. Trägerelemente 5 eintreten und von diesen im wesentlichen vollständig umschlossen werden, sind bei der in Fig. 5 und 6 dargestellten Ausführungsform die Kopplungselemente 24 an einem oberen Teilbereich der einzelnen Leiterplatten 21 ausgebildet, wie dies aus Fig. 6 deutlich ersichtlich ist.

In einem zusammengebauten Zustand, wie er in Fig. 6 angedeutet ist, sind die Kopplungselemente 26 der Rahmen- bzw. Trägerelemente 25 in Form von abgesetzten Bereichen bzw. Vertiefungen entsprechend der Dicke der Kopplungselemente 24 vertieft ausgebildet, so daß in zusammengebautem Zustand eine im wesentlichen plane Oberfläche im Bereich der Verbindung der Kopplungselemente 24 und 26 vorgesehen ist.

Für ein zuverlässiges Festlegen der Kopplungselemente 24 der Leiterplatten 21 in den abgesetzten Vertiefungen 26 an den Rahmen- bzw. Trägerelementen 25 ist darüber hinaus vorgesehen, wie dies in Fig. 7 und 8 schematisch angedeutet ist, daß im Bereich der Kopplungsstelle in Form der abgesetzten Vertiefung 26 über eine Abgabevorrichtung 27 ein Kleber 28 aufgebracht wird, so daß in weiterer Folge eine zuverlässige Festlegung der Kopplungselemente 24 im Bereich der Kopplungselemente 26 erzielbar ist.

Ein automatisiertes Zusammenbauen der Leiterplatten 21 mit den Rahmen- bzw. Trägerelementen 25 kann ebenso wie bei der in Fig. 3 und 4 dargestellten Ausführungsform vorgenommen werden, wobei zusätzlich Abgabevorrichtungen für Klebstoff vorzusehen sind.

Anstelle eines Vorsehens von jeweils zwei Rahmen- bzw. Trägerelementen 5 bzw. 25 an einander gegenüberliegenden Rändern bzw. Seitenkanten 2 und 3 bzw. 22 und 23 der Leiterplatten 1 und 21 kann mit lediglich einem Rahmen- bzw. Trägerelement 5 an einem Seitenrand 2 oder 3 bzw. 22 oder 23 für eine Verbindung mit der Mehrzahl von Leiterplatten 1 bzw. 21 das Auslangen gefunden werden.

Darüber hinaus kann insbesondere bei Vorsehen von Rahmen- bzw. Trägerelementen 5 bzw. 25 an gegenüberliegenden Seitenrändern bzw. -kanten der Leiterplatten 1 bzw. 21 zumindest an einem Seitenrand mit einem einzigen Kopplungselement 4 bzw. 24 und entsprechend einem einzigen Kopplungselement 6 bzw. 26 an den Rahmen- bzw. Trägerelementen 5 bzw. 25 das Auslangen gefunden werden.

Darüber hinaus kann anstelle eines Verbindens von vier Leiterplatten 1 bzw. 21 mit jeweils wenigstens einem gemeinsamen Rahmen- bzw. Trägerelement 5 bzw. 25 auch eine davon unterschiedliche Anzahl von Leiterplatten 1 entsprechend insbesondere den Verfahrensschritten in nachfolgenden Be- bzw. Verarbeitungsvorgängen gewählt werden.

Weiters ist denkbar, daß die Kopplungselemente, welche an den Rahmen- bzw. Trägerelementen 5 bzw. 25 vorgesehen sind, von von Seitenrändern bzw. -kanten derselben vorragenden Kopplungselementen gebildet sind, welche in entsprechende komplementäre Vertiefungen bzw. Ausnehmungen an Seitenrändern bzw. -kanten der Leiterplatten 1 bzw. 21 eingreifen und in bzw. an diesen festgelegt werden.

## Patentansprüche

1. Verfahren zum Verbinden einer Mehrzahl von Leiterplatten mit wenigstens einem Rahmen- bzw. Trägerelement, umfassend die folgenden Schritte:
- Bereitstellen einer Mehrzahl von Leiterplatten (1, 21), welche an wenigstens einem Rand (2, 3, 22, 23) mit jeweils wenigstens einem Kopplungselement (4, 24) ausgebildet werden,
- Bereitstellen wenigstens eines Rahmen- bzw. Trägerelements (5) zur Kopplung mit einer Mehrzahl von Leiterplatten (1, 21) mit zu dem wenigstens einen Kopplungselement (4, 24) der Leiterplatten (1, 21) jeweils komplementären Kopplungselementen (6, 26), und
- Koppeln bzw. Verbinden der Leiterplatten (1, 21) mit dem wenigstens einen Rahmen- bzw. Trägerelement (5) durch Zusammenpassen der Kopplungselemente (4, 24, 6, 26) der Leiterplatten (1, 21) und des Rahmen- bzw. Trägerelements (5, 25),
wobei das wenigstens eine Rahmen- bzw. Trägerelement (5, 25) die Leiterplatten (1, 21) lediglich über einen Teilbereich des Umfangs umgibt bzw. umschließt,
**dadurch gekennzeichnet,**
**dass** das wenigstens eine Kopplungselement (4, 24) der Leiterplatte (1, 21) von einem einen sich verjüngenden Querschnitt aufweisenden Kopplungselement (4, 24) gebildet wird und dass die Kopplung bzw. Verbindung der Leiterplatten (1, 21) mit dem wenigstens einen Rahmen- bzw. Trägerelement (5, 25) in einer horizontalen Anordnung bzw. Positionierung geschieht.

2. Verfahren nach Anspruch 1, **dadurch gekennzeichnet, dass** das jeweils wenigstens eine Kopplungselement (4, 24) der Leiterplatten (1, 21) und die komplementären Kopplungselemente (6, 26) des Rahmen- bzw. Trägerelements (5) formschlüssig verbunden werden.

3. Verfahren nach Anspruch 1 oder 2, **dadurch gekennzeichnet, dass** das wenigstens eine Kopplungselement (24) der Leiterplatten (21) mit den komplementären Kopplungselementen (26) des Rahmen- bzw. Trägerelements (25) verklebt wird.

4. Verfahren nach einem der Ansprüche 1 bis 3, **dadurch gekennzeichnet, dass** das wenigstens eine Kopplungselement (4, 24) der Leiterplatten (1, 21) von einem profilierten, von einem Rand (2, 3, 22, 23) der Leiterplatte vorragenden Kopplungselement (4, 24) gebildet wird, welches in einer komplementären Ausnehmung bzw. Vertiefung (6, 26) des Rahmen- bzw. Trägerelements (5, 25) aufgenommen wird.

5. Verfahren nach Anspruch 4, **dadurch gekennzeichnet, dass** das wenigstens eine Kopplungselement (4, 24) der Leiterplatte (1, 21) von einem einen dreieckigen Querschnitt aufweisenden Kopplungselement (4, 24) gebildet wird.

6. Verfahren nach einem der Ansprüche 1 bis 5, **dadurch gekennzeichnet, dass** eine Mehrzahl von Leiterplatten (1, 21) voneinander beabstandet mit dem wenigstens einen Rahmen- bzw. Trägerelement (5, 25) verbunden wird.

7. Verfahren nach einem der Ansprüche 1 bis 6, **dadurch gekennzeichnet, dass** die Leiterplatten (1, 21) an zwei gegenüberliegenden Rändern (2, 3, 22, 23) mit jeweils wenigstens einem Kopplungselement (4, 24) ausgebildet werden, welche mit an den gegenüberliegenden Rändern (2, 3, 22, 23) der Leiterplatten (1, 21) vorgesehenen Rahmen- bzw. Trägerelementen (5, 25) zusammenwirken.

8. Verfahren nach einem der Ansprüche 1 bis 7, **dadurch gekennzeichnet, dass** eine Mehrzahl von voneinander beabstandeten Leiterplatten (1) auf einem Förderelement (9) in eine für eine Verbindung mit dem wenigstens einen Rahmen- bzw. Trägerelement (5) vorgesehene gegenseitige Positionierung gebracht wird, dass das wenigstens eine Rahmen- bzw. Trägerelement (5) in einer auf die Zufuhrrichtung (8) der Leiterplatten (1) im wesentlichen normalen Zufuhrrichtung (10, 11) in Richtung zu den mit den Kopplungselementen (4) versehenen Rändern (2, 3) der Leiterplatten (1) bewegt wird und dass die Kopplungselemente (4) der Leiterplatten (1) mit den Kopplungselementen (6) des Rahmen- bzw. Trägerelements (5) gekoppelt bzw. verbunden werden.

9. Verfahren nach Anspruch 8, **dadurch gekennzeichnet, dass** nach einer Positionierung einer Mehrzahl von Leiterplatten (1) an einer für eine Kopplung vorgesehenen Position zwei Rahmen- bzw. Trägerelemente (5) in zueinander entgegengesetzten Richtungen (10, 11) in Richtung zu den mit den Kopplungselementen (4) versehenen Leiterplatten (1) bewegt und mit diesen verbunden werden.

10. Verfahren nach Anspruch 8 oder 9, **dadurch gekennzeichnet, dass** die Leiterplatten (1) und/oder Rahmen- bzw. Trägerelemente (5) während der Kopplung miteinander durch Halte- bzw. Klemmelemente (16) positioniert und gehalten werden.

11. System zum Verbinden einer Mehrzahl von Leiterplatten mit wenigstens einem Rahmen- bzw. Trägerelement, umfassend die folgenden Elemente:
- eine Mehrzahl von Leiterplatten (1, 21), welche an wenigstens einem Rand (2, 3, 22, 23) mit jeweils wenigstens einem Kopplungselement (4, 24) ausgebildet sind, und
- wenigstens ein Rahmen- bzw. Trägerelement (5, 25) zur Kopplung mit einer Mehrzahl von Leiterplatten (1) mit zu dem wenigstens einen Kopplungselement (4, 24) der Leiterplatten (1, 21) jeweils komplementären Kopplungselementen (6, 26),
wobei die Leiterplatten (1, 21) mit dem wenigstens einen Rahmen- bzw. Trägerelement (5, 25) durch Zusammenpassen der Kopplungselemente (4, 24, 6, 26) der Leiterplatten (1, 21) und des Rahmen- bzw. Trägerelements (5, 25) koppelbar sind, wobei nach der Kopplung das wenigstens eine Rahmen- bzw. Trägerelement (5, 25) die Leiterplatten (1, 21) lediglich über einen Teilbereich des Umfangs umgibt bzw. umschließt,
**dadurch gekennzeichnet,**
**dass** das wenigstens eine Kopplungselement (4, 24) der Leiterplatte (1, 21) von einem einen sich verjüngenden Querschnitt aufweisenden Kopplungselement (4, 24) gebildet ist und dass die Kopplung bzw. Verbindung der Leiterplatten (1, 21) mit dem wenigstens einen Rahmen- bzw. Trägerelement (5, 25) in einer horizontalen Anordnung bzw. Positionierung geschehen kann wobei die Leiterplatten (1, 21) und das wenigstens eine Rahmen- bzw. Trägerelement (5, 25) bei der Kopplung bzw. Verbindung auf gleicher Höhe bzw. in einer Ebene angeordnet sein können.

12. System nach Anspruch 11, **dadurch gekennzeichnet, dass** das jeweils wenigstens eine Kopplungselement (4, 24) der Leiterplatten (1, 21) von einem profilierten, von einem Rand (2, 3, 22, 23) der Leiterplatte (1, 21) vorragenden Kopplungselement (4, 24) gebildet ist, welches in einer komplementären Ausnehmung bzw. Vertiefung (6, 26) des Rahmen- bzw. Trägerelements (5, 25) aufnehmbar ist.

13. System nach Anspruch 11 oder 12, **dadurch gekennzeichnet, dass** das wenigstens eine Kopplungselement (4, 24) der Leiterplatte (1, 21) von einem einen dreieckigen Querschnitt aufweisenden Kopplungselement (4, 24) gebildet ist.

14. System nach einem der Ansprüche 11 bis 13, **dadurch gekennzeichnet, dass** die Kopplungselemente (26) des Rahmen- bzw. Trägerelements (25) von jeweils einem von der Oberfläche des Rahmen- bzw. Trägerelements (25) abgesetzten Teilbereich (26) gebildet sind, in welchen jeweils ein Kopplungselement (24) einer Leiterplatte (21) einpaßbar ist.

15. System nach einem der Ansprüche 11 bis 13, **dadurch gekennzeichnet, dass** die Kopplungselemente (6) des Rahmen- bzw. Trägerelements (5) von an einem Seitenrand, welcher zu den Leiterplatten (1) gerichtet ist, gebildeten Hohlräumen bzw. Vertiefungen (6) gebildet sind.

16. System nach einem der Ansprüche 11 bis 15, **dadurch gekennzeichnet, dass** die Leiterplatten (1, 21) an zwei gegenüberliegenden Rändern (2, 3, 22, 23) mit jeweils wenigstens einem Kopplungselement (4, 24) ausgebildet sind, welche mit an den gegenüberliegenden Rändern der Leiterplatten (1, 21) vorgesehenen Rahmen- bzw. Trägerelementen (5, 25) zusammenwirken können.

## Claims

1. A method for connecting a plurality of printed circuit boards to at least one frame or carrier element, comprising the steps of:
- providing a plurality of printed circuit boards (1, 21) which are each designed to have at least one coupling element (4, 24) on at least one edge (2, 3, 22, 23),
- providing at least one frame or carrier element (5) for coupling to a plurality of printed circuit boards (1, 21) using coupling elements (6, 26) that in each case complement the at least one coupling element (4, 24) of the printed circuit boards (1, 21), and
- coupling or connecting the printed circuit boards (1, 21) to the at least one frame or carrier element (5) by fitting together the coupling elements (4, 24, 6, 26) of the printed circuit boards (1, 21) and the frame or carrier element(5, 25),
wherein the at least one frame or carrier element (5, 25) only surrounds or encloses the printed circuit boards (1, 21) over a partial region of the periphery,
**characterized in that**
the at least one coupling element (4, 24) of the printed circuit board is formed by a coupling element (4, 24) having a tapering cross section and that the coupling or connection of the printed circuit boards (1, 21) with the at least one frame or carrier element (5, 25) takes place with a horizontal arrangement or positioning.

2. A method according to claim 1, **characterized in that** the respective at least one coupling element (4, 24) of the printed circuit boards (1, 21) and the complementary coupling elements (6, 26) of the frame or carrier element (5) are positively connected.

3. A method according to claim 1 or 2, **characterized in that** the at least one coupling element (24) of the printed circuit boards (21) is glued with the complementary coupling elements (26) of the frame or carrier element (25).

4. A method according to any one of claims 1 to 3, **characterized in that** the at least one coupling element (4, 24) of the printed circuit boards (1, 21) is formed by a profiled coupling element (4, 24) projecting from an edge (2, 3, 22, 23) of the printed circuit board and received in a complementary recess or depression (6, 26) of the frame or carrier element (5, 25).

5. A method according to claim 4, **characterized in that** the at least one coupling element (4, 24) of the printed circuit board (1, 21) is formed by a coupling element (4, 24) having a triangular cross section.

6. A method according to any one of claims 1 to 5, **characterized in that** a plurality of printed circuit boards (1, 21) are connected to the at least one frame or carrier element (5, 25) in a mutually spaced-apart relationship.

7. A method according to any one of claims 1 to 6, **characterized in that** the printed circuit boards (1, 21), on two oppositely located edges (2, 3, 22, 23), are each designed to have at least one coupling element (4, 24), which cooperate with frame or carrier elements (5, 25) provided on the oppositely located edges (2, 3, 22, 23) of the printed circuit boards (1, 21).

8. A method according to any one of claims 1 to 7, **characterized in that** a plurality of mutually spaced-apart circuit boards (1) on a conveying element (9) are brought into mutual positions provided for a connection to the at least one frame or carrier element (5), that the at least one frame or carrier element (5) is moved in a supply direction (10, 11) substantially normal to the supply direction (8) of the printed circuit boards (1) towards the printed circuit board edges (2, 3) provided with the coupling elements (4), and that the coupling elements (4) of the printed circuit boards (1) are coupled or connected to the coupling elements (6) of the frame or carrier element (5).

9. A method according to claim 8, **characterized in that**, after having positioned a plurality of printed circuit boards (1) in a position provided for coupling, two frame or carrier elements (5) are moved in mutually opposite directions (10, 11) towards the printed circuit boards (1) provided with the coupling elements (4) and are connected with the same.

10. A method according to claim 8 or 9, **characterized in that** the printed circuit boards (1) and/or the frame or carrier elements (5) are positioned and held together by holding or clamping elements (16).

11. A system for connecting a plurality of printed circuit boards to a frame or carrier element, comprising the following elements:
- a plurality of printed circuit boards (1, 21) which are each designed to have at least one coupling element (4, 24) on at least one edge (2, 3, 22, 23), and
- at least one frame or carrier element (5, 25) for coupling to a plurality of printed circuit boards (1) using coupling elements (6, 26) that in each case complement the at least one coupling element (4, 24) of the printed circuit boards (1, 21),
wherein the printed circuit boards (1, 21) can be coupled to the at least one frame or carrier element (5, 25) by fitting together the coupling elements (4, 24, 6, 26) of the printed circuit boards (1, 21) and the frame or carrier element (5, 25),
wherein after coupling the at least one frame or carrier element (5, 25) only surrounds or encloses the printed circuit boards (1, 21) over a partial region of the periphery,
**characterized in that**
the at least one coupling element (4, 24) of the circuit board is formed by a coupling element (4, 24) having a tapering cross section and that the coupling or connection of the printed circuit boards (1, 21) with the at least one frame or carrier element (5, 25) may take place with a horizontal arrangement or positioning, wherein the printed circuit boards (1, 21) and the at least one frame or carrier element (5, 25) may be arranged at the same height or in one plane during coupling or connecting.

12. A system according to claim 11, **characterized in that** the respective at least one coupling element (4, 24) of the printed circuit boards (1, 21) is formed by a profiled coupling element (4, 24) projecting from an edge (2, 3, 22, 23) of the printed circuit board (1, 21) and receivable in a complementary recess or depression (6, 26) of the frame or carrier element (5, 25).

13. A system according to claim 11 or 12, **characterized in that** the at least one coupling element (4, 24) of the printed circuit board (1, 21) is formed by a coupling element (4, 24) having a triangular cross section.

14. A system according to any one of claims 11 to 13, **characterized in that** the coupling elements (26) of the frame or carrier element (25) are each formed by a partial region (26) offset from the surface of the frame or carrier element (25), in which a coupling element (24) of a printed circuit board (21) can each be fitted.

15. A system according to any one of claims 11 to 13, **characterized in that** the coupling elements (6) of the frame or carrier element (5) are comprised of cavities or depressions (6) formed on a side edge oriented to the printed circuit boards (1).

16. A system according to any one of claims 11 to 15, **characterized in that** the printed circuit boards (1, 21), on two oppositely located edges (2, 3, 22, 23), are each designed to have at least one coupling element (4, 24), which may cooperate with frame or carrier elements (5, 25) provided on the oppositely located edges of the printed circuit boards (1, 21).

## Revendications

1. Procédé de connexion d'une pluralité de cartes de circuit imprimé à au moins un élément support ou cadre, comprenant les étapes suivantes :
- la fourniture d'une pluralité de cartes de circuit imprimé (1, 21) qui sont réalisées au niveau d'au moins un bord (2, 3, 22, 23) avec respectivement au moins un élément de couplage (4, 24),
- la fourniture d'au moins un élément support ou cadre (5) pour le couplage à une pluralité de cartes de circuit imprimé (1, 21) avec des éléments de couplage (6, 26) respectifs complémentaires à l'au moins un élément de couplage (4, 24) des cartes de circuit imprimé (1, 21), et
- le couplage ou la connexion des cartes de circuit imprimé (1, 21) à l'au moins un élément support ou cadre (5) par l'adaptation des éléments de couplage (4, 24, 6, 26) des cartes de circuit imprimé (1, 21) et de l'élément support ou cadre (5, 25),
dans lequel l'au moins un élément support ou cadre (5, 25) entoure ou enferme les cartes de circuit imprimé (1, 21) uniquement sur une zone partielle du périmètre,
**caractérisé en ce**
**que** l'au moins un élément de couplage (4, 24) de la carte de circuit imprimé (1, 21) est formé par un élément de couplage (4, 24) présentant une section transversale se rétrécissant et en ce que le couplage ou la connexion des cartes de circuit imprimé (1, 21) est effectué avec l'au moins un élément support ou cadre (5, 25) dans un agencement ou positionnement horizontal.

2. Procédé selon la revendication 1, **caractérisé en ce que** respectivement au moins un élément de couplage (4, 24) des cartes de circuit imprimé (1, 21) et les éléments de couplage (6, 26) complémentaires de l'élément support ou cadres (5) sont connectés par complémentarité de forme.

3. Procédé selon la revendication 1 ou 2, **caractérisé en ce que** l'au moins un élément de couplage (24) des cartes de circuit imprimé (21) est collé avec les éléments de couplage (26) complémentaires de l'élément support ou cadre (25).

4. Procédé selon l'une quelconque des revendications 1 à 3, **caractérisé en ce que** l'au moins un élément de couplage (4, 24) des cartes de circuit imprimé (1, 21) est formé par un élément de couplage (4, 24) profilé, faisant saillie d'un bord (2, 3, 22, 23) de la carte de circuit imprimé, qui est logé dans un logement ou évidement (6, 26) complémentaire de l'élément support ou cadre (5, 25).

5. Procédé selon la revendication 4, **caractérisé en ce que** l'au moins un élément de couplage (4, 24) de la carte de circuit imprimé (1, 21) est formé par un élément de couplage (4, 24) présentant une section transversale triangulaire.

6. Procédé selon l'une quelconque des revendications 1 à 5, **caractérisé en ce qu'**une pluralité de cartes de circuit imprimé (1, 21) sont connectées écartées les unes des autres à l'au moins un élément support ou cadre (5, 25).

7. Procédé selon l'une quelconque des revendications 1 à 6, **caractérisé en ce que** les cartes de circuit imprimé (1, 21) sont réalisées au niveau de deux bords (2, 3, 22, 23) opposés avec respectivement au moins un élément de couplage (4, 24) qui coopère avec des éléments support ou cadre (5, 25) prévus au niveau des bords (2, 3, 22, 23) opposés des cartes de circuit imprimé (1, 21).

8. Procédé selon l'une quelconque des revendications 1 à 7, **caractérisé en ce qu'**une pluralité de cartes de circuit imprimé (1) écartées les unes des autres sont déposées sur un élément de transport (9) selon un positionnement réciproque prévu pour une connexion à l'au moins un élément support ou cadre (5), **en ce que** l'au moins un élément support ou cadre (5) est déplacé dans une direction d'amenée (10, 11) sensiblement normale à la direction d'amenée (8) des cartes de circuit imprimé (1) en direction des bords (2, 3) des cartes de circuit imprimé (1) pourvus des éléments de couplage (4) et **en ce que** les éléments de couplage (4) des cartes de circuit imprimé (1) sont couplés ou connectés aux éléments de couplage (6) de l'élément support ou cadre (5).

9. Procédé selon la revendication 8, **caractérisé en ce que**, après un positionnement d'une pluralité de cartes de circuit imprimé (1) au niveau d'une position prévue pour un couplage, deux éléments support ou cadre (5) sont déplacés dans des directions (10, 11) opposées l'une à l'autre en direction des cartes de circuit imprimé (1) pourvues des éléments de couplage (4) et connectés à celles-ci.

10. Procédé selon la revendication 8 ou 9, **caractérisé en ce que** les cartes de circuit imprimé (1) et/ou les éléments support ou cadre (5) sont positionnés et maintenus entre eux durant le couplage par des éléments de retenue ou de serrage (16).

11. Système de connexion d'une pluralité de cartes de circuit imprimé à au moins un élément support ou cadre, comprenant les éléments suivantes :
- une pluralité de cartes de circuit imprimé (1, 21) qui sont réalisées au niveau d'au moins un bord (2, 3, 22, 23) avec respectivement au moins un élément de couplage (4, 24), et
- au moins un élément support ou cadre (5, 25) pour le couplage à une pluralité de cartes de circuit imprimé (1) avec des éléments de couplage (6, 26) respectifs complémentaires à l'au moins un élément de couplage (4, 24) des cartes de circuit imprimé (1, 21),
dans lequel les cartes de circuit imprimé (1, 21) peuvent être couplées à l'au moins un élément support ou cadre (5, 25) par adaptation des éléments de couplage (4, 24, 6, 26) des cartes de circuit imprimé (1, 21) et de l'élément support ou cadre (5, 25),
dans lequel, après le couplage, l'au moins un élément support ou cadre (5, 25) entoure ou enferme les cartes de circuit imprimé (1, 21) uniquement sur une zone partielle du périmètre,
**caractérisé en ce**
**que** l'au moins un élément de couplage (4, 24) de la carte de circuit imprimé (1, 21) est formé par un élément de couplage (4, 24) présentant une section transversale se rétrécissant et en ce que le couplage ou la connexion des cartes de circuit imprimé (1, 21) peut être effectué avec l'au moins un élément support ou cadre (5, 25) dans un agencement ou positionnement horizontal,
dans lequel les cartes de circuit imprimé (1, 21) et l'au moins un élément support ou cadre (5, 25) peuvent être disposés, lors du couplage ou de la connexion, à la même hauteur ou dans un plan.

12. Système selon la revendication 11, **caractérisé en ce que** respectivement au moins un élément de couplage (4, 24) des cartes de circuit imprimé (1, 21) est formé par un élément de couplage (4, 24) profilé, faisant saillie d'un bord (2, 3, 22, 23) de la carte de circuit imprimé (1, 21), qui peut être logé dans un logement ou évidement (6, 26) complémentaire de l'élément support ou cadre (5, 25).

13. Système selon la revendication 11 ou 12, **caractérisé en ce que** l'au moins un élément de couplage (4, 24) de la carte de circuit imprimé (1, 21) est formé par un élément de couplage (4, 24) présentant une section transversale triangulaire.

14. Système selon l'une quelconque des revendications 11 à 13, **caractérisé en ce que** les éléments de couplage (26) de l'élément support ou cadre (25) sont formés respectivement par une zone partielle (26), décalée de la surface de l'élément support ou cadre (25), dans chacune desquelles un élément de couplage (24) d'une carte de circuit imprimé (21) peut être adapté.

15. Système selon l'une quelconque des revendications 11 à 13, **caractérisé en ce que** les éléments de couplage (6) de l'élément support ou cadres (5) sont formés par des espaces creux ou évidements (6) formés au niveau d'un bord latéral qui est orienté vers les cartes de circuit imprimé (1).

16. Système selon l'une quelconque des revendications 11 à 15, **caractérisé en ce que** les cartes de circuit imprimé (1, 21) sont réalisées au niveau de deux bords (2, 3, 22, 23) opposés avec respectivement au moins un élément de couplage (4, 24) qui peut coopérer avec des éléments support ou cadre (5, 25) prévus au niveau des bords opposés des cartes de circuit imprimé (1, 21).
